(19) **Europäisches Patentamt**
**European Patent Office**
**Office européen des brevets**

(11) **EP 2 776 853 B1**

(12) **FASCICULE DE BREVET EUROPEEN**

(45) Date de publication et mention
de la délivrance du brevet:
**12.10.2016 Bulletin 2016/41**

(21) Numéro de dépôt: **12780511.7**

(22) Date de dépôt: **06.11.2012**

(51) Int Cl.:
***G01R 15/20*** *(2006.01)*

(86) Numéro de dépôt international:
**PCT/EP2012/071951**

(87) Numéro de publication internationale:
**WO 2013/068360 (16.05.2013 Gazette 2013/20)**

(54) **DISPOSITIF DE MESURE DE COURANTS DANS LES CONDUCTEURS D'UN CABLE GAINE D'UN RESEAU POLYPHASE**

VORRICHTUNG ZUR MESSUNG VON STRÖMEN IN LEITUNGEN EINES UMMANTELTEN KABELS EINES MEHRPHASIGEN NETZES

DEVICE FOR MEASURING CURRENTS IN THE CONDUCTORS OF A SHEATHED CABLE OF A POLYPHASE NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2011 FR 1103443**

(43) Date de publication de la demande:
**17.09.2014 Bulletin 2014/38**

(73) Titulaires:
• **Université Lyon 1 Claude Bernard**
**69100 Villeurbanne (FR)**
• **Ecole Centrale de Lyon**
**69134 Ecully Cedex (FR)**
• **Centre National de la Recherche Scientifique**
**75016 Paris (FR)**
• **Institut National Des Sciences Appliquées De Lyon**
**69621 Villeurbanne (FR)**
• **Electricité de France**
**75008 Paris (FR)**
• **Socomec**
**67230 Benfeld (FR)**
• **Kapteos**
**73376 Le Bourget-du-Lac Cedex (FR)**

(72) Inventeurs:
• **BOURKEB, Menad**
**F-69622 Villeurbanne (FR)**

• **JOUBERT, Charles**
**F-69622 Villeurbanne (FR)**
• **SCORRETTI, Riccardo**
**F-69622 Villeurbanne (FR)**
• **ONDEL, Olivier**
**F-69622 Villeurbanne (FR)**
• **YAHOUI, Hamed**
**F-69622 Villeurbanne (FR)**
• **MOREL, Laurent**
**F-69622 Villeurbanne (FR)**
• **DUVILLARET, Lionel**
**F-73000 Chambery (FR)**
• **KERN, Christian**
**F-68240 Sigolsheim (FR)**
• **SCHMITT, Gilbert**
**F-77167 Poligny (FR)**

(74) Mandataire: **GIE Innovation Competence Group**
**310, avenue Berthelot**
**69372 Lyon Cedex 08 (FR)**

(56) Documents cités:
**EP-A1- 1 624 313    EP-A2- 0 597 404**
**WO-A1-01/50142    FR-A1- 2 872 580**
**US-A- 5 473 244    US-A1- 2009 048 806**
**US-B1- 7 755 347**

**Description**

L'invention concerne la mesure de courant dans les réseaux électriques, et en particulier la mesure de courant dans des câbles gainés incluant plusieurs conducteurs.

La gestion de la consommation d'énergie électrique nécessite notamment de disposer d'outils satisfaisants pour mesurer, suivre et contrôler cette énergie. La maintenance de réseau électrique nécessite également fréquemment de pouvoir réaliser des mesures de courant.

En particulier dans des applications de puissance, il est courant d'utiliser des câbles gainés et incluant plusieurs conducteurs séparés. Chaque conducteur est destiné à transmettre une phase respective d'une alimentation polyphasée, typiquement une alimentation triphasée.

S'il existe en pratique un grand nombre de solutions permettant de mesurer le courant traversant un conducteur simple, peu d'outils permettent la mesure des courants individuels dans les conducteurs d'un câble gainé sans interrompre l'alimentation électrique et sans connecter une charge électrique sur ce réseau. De telles interruptions de l'alimentation électrique sont néfastes pour assurer la continuité de service du réseau et peuvent en outre induire des problématiques de sécurité.

Le document US 5473244 décrit un appareil pour réaliser des mesures sans contact de tension, courant, et puissance dans des éléments conducteurs. L'appareil comprend des capteurs capacitifs pour générer un premier courant en réponse à une variation de tension dans un élément conducteur. Chaque capteur est positionné dans un champ électrique de l'élément conducteur et est ainsi couplé à l'élément conducteur par couplage capacitif. Une source de référence commande le capteur capacitif à une fréquence de référence pour induire l'écoulement d'un courant de référence. Un réseau de mesure est utilisé pour calculer le couplage capacitif en se basant sur une mesure du courant de référence, pour ainsi déterminer la tension dans l'élément conducteur en se basant sur le premier courant et le couplage capacitif.

Le document WO01/50142 décrit un dispositif de mesure de courant pour des commutateurs de puissance basse tension. Le dispositif de mesure comprend de multiples capteurs de champ magnétique agencés autour d'un élément conducteur de courant dont on souhaite mesurer le courant. Les capteurs réalisent une mesure ponctuelle des champs magnétiques. Le dispositif de mesure comprend en outre des moyens de traitement du signal configuré pour recevoir les signaux de mesure de courant provenant des différents capteurs de champ magnétique. Le positionnement et l'orientation des différents capteurs autour de l'élément conducteur sont réalisés de façon à optimiser la précision de mesure des capteurs. la précision de mesure des capteurs.

Le document US2009/0048806 décrit un procédé de diagnostic d'une électrovanne à papillon. La durée d'alimentation d'un moteur d'entraînement du papillon est déterminée à partir de signaux fournis par de multiples capteurs magnétiques fixés sur un tube logeant un câble d'alimentation du moteur. Ce procédé permet de déterminer avec précision les instants de commutation de l'alimentation du moteur.

Le document US7755347 décrit un système de mesure permettant de déterminer le courant électrique à l'intérieur de chacun des conducteurs d'un câble polyphasé. Le système de mesure comprend des capteurs de champ magnétique répartis radialement dans un anneau. L'anneau est destiné à entourer le câble à mesurer. Le nombre de capteurs de champ magnétique est un multiple du nombre de conducteurs inclus dans le câble. En fonction de l'intensité du champ mesuré par chacun des capteurs, le système détermine d'abord pour chaque conducteur quel capteur est le plus proche de lui. Le système sélectionne alors la mesure des capteurs qui sont les plus proches de conducteurs respectifs. À partir de la connaissance de la structure du câble et du positionnement des conducteurs, il est possible de calculer l'intensité dans chacun de ces conducteurs.

Un tel système de mesure présente cependant des inconvénients. Un tel système de mesure présente une relative imprécision ou nécessite un grand nombre de capteurs. Un tel système de mesure ne permet en outre pas de réaliser une mesure sans connaître au préalable très précisément la structure du câble dans lequel la mesure est effectuée, ce qui se révèle en pratique impossible lors de la plupart des interventions de maintenance. L'usage d'un tel système de mesure se trouve ainsi extrêmement limité.

L'invention vise à résoudre un ou plusieurs de ces inconvénients. L'invention porte ainsi sur un dispositif de mesure de courants dans les conducteurs d'un câble gainé d'un réseau polyphasé, comprenant :

- au moins trois capteurs magnétiques disposés autour d'un orifice central destiné à être traversé par le câble à mesurer présentant un nombre de conducteurs inférieur au nombre de capteurs ;
- un dispositif de calcul configuré pour :

    - accéder à une bibliothèque de matrices [K] et [K]$^+$, avec [I]=[K]$^+$.[B] pour une configuration de câble donnée et une position angulaire donnée des capteurs autour de ce câble donné, avec [I] un vecteur de courant traversant le câble ayant la configuration donnée lorsqu'un vecteur de champ magnétique [B] est mesuré sur lesdits capteurs, avec [K]$^+$ une matrice pseudo-inverse de la matrice [K] ;

- former un vecteur [B] incluant une mesure de champ magnétique de chacun desdits capteurs ;
- pour différentes configurations de câbles et différentes positions angulaires desdits capteurs par rapport à ces câbles, calculer un vecteur résiduel [R] = [K].[K]$^+$.[B] - [B] ;
- sélectionner la matrice [K]$^+$ pour laquelle la norme du vecteur [R] est minimale ;
- calculer [I] = [K]$^+$.[B] avec [K]$^+$ ladite matrice sélectionnée.

Selon une variante, le dispositif de mesure comprend en outre une mémoire mémorisant ladite bibliothèque de matrices, ladite mémoire étant accessible par le dispositif de calcul.

Selon une autre variante, le dispositif de mesure comprend au moins six capteurs magnétiques répartis uniformément autour dudit orifice central.

Selon encore une variante, le dispositif de mesure de courant comprend en outre un blindage magnétique, lesdits capteurs étant disposés entre deux faces latérales et une face radiale externe dudit blindage.

Selon encore une autre variante, la bibliothèque de matrices comprend plusieurs matrices [K] et [K]$^+$ pour une même configuration de câble donnée, lesdites matrices [K] et [K]$^+$ pour cette même configuration correspondant à différentes positions angulaires des capteurs par rapport à ce câble, l'écart entre ces positions angulaires étant inférieur ou égal à 10°.

L'invention porte également sur un procédé de mesure de courant dans M conducteurs d'un câble gainé d'un réseau polyphasé, avec M au moins égal à 2, le procédé comprenant les étapes de :

- disposer N capteurs magnétiques autour d'une section du câble, avec N supérieur à M ;
- former un vecteur [B] incluant la mesure de champ magnétique de chacun desdits capteurs ;
- pour différentes configurations de câbles et différentes positions angulaires des N capteurs par rapport à ces câbles, calculer un vecteur résiduel [R] = [K].[K]$^+$.[B] - [B], avec [K] une matrice définie telle que [I] = [K]$^+$.[B] pour une configuration de câble donnée et pour une position angulaire donnée des N capteurs autour de ce câble donné, avec [K]$^+$ une matrice pseudo-inverse de la matrice [K], avec [I] le courant traversant le câble de la configuration donnée avec la position angulaire donnée des N capteurs ;
- sélectionner la matrice [K]$^+$ pour laquelle la norme du vecteur [R] est minimale ;
- calculer [I] = [K]$^+$. [B] avec [K]$^+$ ladite matrice sélectionnée.

Selon une variante, M est égal à 3.

Selon encore une variante, on dispose au moins six capteurs magnétiques répartis uniformément autour dudit orifice central.

Selon une autre variante, le calcul du vecteur résiduel est réalisé avec plusieurs matrices [K] et [K]$^+$ pour une même configuration de câble donnée, lesdites matrices [K] et [K]$^+$ pour cette même configuration correspondant à différentes positions angulaires des capteurs par rapport à ce câble, l'écart entre ces positions angulaires étant inférieur ou égal à 10°.

Selon encore une autre variante, [K]$^+$ est la matrice pseudo inverse de Penrose de la matrice [K].

Selon une variante, lesdits capteurs sont disposés dans un même plan perpendiculaire à l'axe du câble.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en coupe d'un exemple de câble pour du courant triphasé ;
- la figure 2 est une vue en coupe d'un dispositif de mesure de l'intensité selon un exemple de mode de réalisation de l'invention ;
- la figure 3 est une vue en coupe du dispositif au niveau de son anneau de mesure ;
- la figure 4 est une vue en coupe de l'anneau mis en place sur un câble ;
- la figure 5 est une vue en coupe d'une variante d'anneau de mesure ;
- la figure 6 est une vue en coupe d'une configuration ayant servi à une simulation.

L'invention propose de mesurer les courants dans les conducteurs d'un câble gainé d'un réseau polyphasé. Pour cela, on dispose au moins trois capteurs de champ magnétique autour d'une section du câble, le nombre de capteurs étant supérieur au nombre de conducteurs dans lesquels on souhaite mesurer le courant. Les capteurs réalisent une mesure du champ magnétique émis par le câble. On teste ensuite l'adéquation entre les champs mesurés et des matrices représentatives de différentes configurations de câbles et de différentes orientations des capteurs par rapport à ces configurations de câbles. On accède pour cela à une bibliothèque de matrices [K] représentative. Une fois que l'on a identifié une matrice [K] correspondant à une adéquation maximale, on calcule les courants dans les conducteurs [I] = [K]$^+$. [B], avec [B] un vecteur incluant une mesure de champ magnétique de chacun des capteurs.

L'invention permet de réaliser une mesure de courant dans plusieurs conducteurs d'un câble à l'intérieur d'une gaine, de façon sûre, sans nécessiter une interruption de l'alimentation électrique et sans nécessiter une connaissance précise de la structure de ce câble.

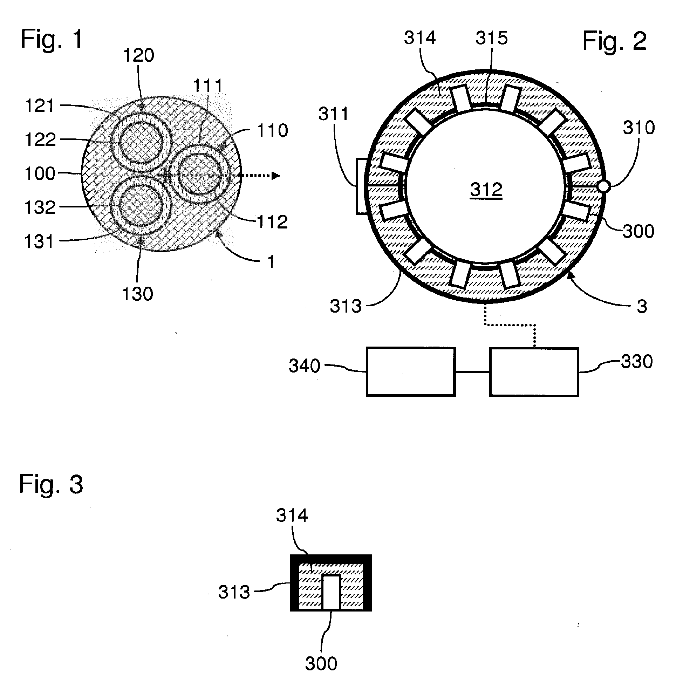

La figure 1 est une vue en coupe d'un exemple de câble 1 pour lequel une mesure par un dispositif de mesure selon l'invention s'avère particulièrement avantageux. Le câble 1 est un câble comprenant un nombre M de conducteurs, avec M au moins égal à 2. Les conducteurs présents à l'intérieur du câble 1 ne sont pas accessibles car disposés à l'intérieur d'une gaine de protection 100. Le câble 1 est en l'occurrence un câble destiné à conduire du courant triphasé et comporte ainsi trois conducteurs respectivement 110, 120 et 130. Les conducteurs 110, 120 et 130 comportent des fils conducteurs respectifs 112, 122 et 132. Les fils conducteurs 112, 122 et 132 sont typiquement réalisés en métal et disposés à l'intérieur de gaines isolantes respectives 111, 121 et 131. Lorsque le câble 1 est parcouru par du courant triphasé équilibré, les fils conducteurs 112, 122 et 132 sont parcourus par des courants respectifs déphasés de 120°.

La figure 2 est une représentation en coupe transversale schématique d'un dispositif de mesure de courant 3 selon un exemple de mode de réalisation de l'invention. La figure 3 est une vue en coupe axiale d'un anneau de mesure du dispositif de mesure 3 au niveau d'un capteur magnétique. Le dispositif de mesure de courant 3 comporte un anneau de mesure destiné à venir entourer une section du câble gainé 1. L'anneau de mesure comporte à cet effet un orifice central traversant 312. L'anneau de mesure comporte plusieurs capteurs magnétiques 300 répartis (avantageusement de façon uniforme) autour de l'orifice central 312. L'anneau de mesure comporte un nombre N de capteurs magnétiques supérieur au nombre de conducteurs M dont on souhaite mesurer le courant. En l'occurrence, l'anneau de mesure comporte 12 capteurs magnétiques répartis autour de l'axe de l'orifice central 312. Un tel nombre de capteurs permet d'avoir une très grande précision avec un câble gainé 1 comprenant trois conducteurs pour la conduction d'un courant triphasé. Les capteurs magnétiques 300 sont avantageusement disposés dans un même plan. Les capteurs magnétiques 300 peuvent être solidarisés les uns aux autres par l'intermédiaire d'une ceinture 315. Les capteurs magnétiques 300 peuvent être logés à l'intérieur d'un blindage magnétique 313. Le blindage magnétique permet de limiter les interférences extérieures avec les capteurs 300. Des simulations effectuées avec un blindage 313 ont établi que ce blindage 313 améliorait sensiblement la précision de la mesure de champ magnétique en présence de perturbations extérieures. Le blindage 313 illustré comporte avantageusement une section en U s'étendant sur la périphérie de l'anneau de mesure. Le blindage 313 s'étend sur deux faces latérales et une face radiale externe de l'anneau de mesure. L'intérieur du blindage 313 peut soit être évidé, soit contenir un matériau de remplissage 314 assurant également le maintien en position des capteurs 300. Le matériau de remplissage 314 est alors un matériau comportant une perméabilité relative proche de 1, par exemple un matériau plastique. Le matériau de remplissage 314 peut par exemple être mis en oeuvre sous la forme d'une mousse. Le matériau de remplissage est dépourvu de matériau ferromagnétique. Les capteurs 300 peuvent être de tous types appropriés, par exemple des capteurs à effet Hall ou des magnéto-impédances. Les capteurs 300 comportent avantageusement une sensibilité à la composante tangentielle et/ou à la composante radiale du champ magnétique du câble gainé 1.

Afin de permettre l'insertion du câble 1 dans l'orifice 312, l'anneau de mesure comporte avantageusement deux parties articulées autour d'une articulation 310, permettant de former une ouverture d'introduction du câble 1 du côté opposé à cette charnière 310. L'anneau de mesure comporte avantageusement un fermoir 311 permettant de fixer les deux parties articulées l'une à l'autre et ainsi maintenir en position cet anneau de mesure sur un câble gainé 1 disposé dans l'orifice 312.

Le dispositif de mesure 3 comprend en outre un dispositif de calcul 330 connecté aux capteurs 300 (dans un souci de simplification, la connectique entre le dispositif de calcul 330 et les capteurs 300 n'est pas illustrée). Le dispositif de calcul 330 est configuré pour calculer les courants traversant les conducteurs du câble 1 en fonction des mesures de champ magnétique réalisées par les capteurs 300. Le dispositif de mesure 3 comprend également avantageusement un écran d'affichage 340 permettant d'afficher les valeurs de courant calculées par le dispositif 330.

Dans un premier temps, on génère une bibliothèque de matrices [K] et [K]$^+$ représentatives de la configuration de différents câbles susceptibles d'être mesurés, et représentatives d'une position angulaire des capteurs 300 du dispositif de mesure 3 autour de chacune de ces configurations de câble.

Cette bibliothèque de matrices [K] et [K]$^+$ peut-être générée en laboratoire, par exemple sur la base de simulations par éléments finis des différentes configurations de câbles et de différentes positions angulaires des capteurs 300 du dispositif de mesure 3 autour de ces configurations de câbles. Si différentes configurations d'anneaux de mesure (différents diamètres, différents nombres de capteurs...) sont disponibles pour le dispositif de mesure 3, chaque configuration d'anneaux de mesure comportera sa propre bibliothèque de matrices [K] et [K]$^+$.

La loi de Biot-Savart définit la relation théorique entre le champ magnétique B mesuré par un capteur et le courant s'écoulant à travers un conducteur. Cette relation est linéaire en l'absence de perturbations magnétiques ou de blindage à proximité. Cette relation est basée sur une hypothèse de conducteurs sensiblement droits et infinis.

$$B = \frac{\mu_r}{2.\pi.r}.I$$

Avec r la distance entre le conducteur et le capteur, et $\mu$r la perméabilité relative de l'environnement supposé isotrope et homogène.

Ainsi, en connaissant la position des capteurs et des conducteurs, cette relation permet de déterminer l'intensité traversant les différents conducteurs du câble 1 en fonction du champ magnétique mesuré par les différents capteurs.

Du fait de la linéarité de cette relation, chacun des N capteurs magnétiques mesure la somme des champs magnétiques générés par les M conducteurs. Ces champs Bi mesurés par les capteurs peuvent ainsi s'exprimer comme ceci :

$$B1 = K_{11}.I_1 + K_{12}.I_2 + K_{13}.I_3... + K_{1M}.I_M$$
$$B2 = K_{21}.I_1 + K_{22}.I_2 + K_{23}.I_3... + K_{2M}.I_M$$
$$\vdots$$
$$BN = K_{N1}.I_1 + K_{N2}.I_2 + K_{N3}.I_3... + K_{NM}.I_M$$

Ces champs peuvent ainsi s'exprimer sous forme matricielle [B]=[K].[I] de la façon suivante, avec Kij des paramètres définissant les caractéristiques du câble gainé 1 et du positionnement angulaire du dispositif de mesure 3 :

$$\begin{pmatrix} B_1 \\ \vdots \\ B_N \end{pmatrix} = \begin{pmatrix} K_{11} & \cdots & K_{1N} \\ \vdots & \ddots & \vdots \\ K_{N1} & \cdots & K_{NM} \end{pmatrix} . \begin{pmatrix} I_1 \\ \vdots \\ I_M \end{pmatrix}$$

Les coefficients Kij dépendent seulement des paramètres géométriques et des matériaux du câble gainé 1 et de l'anneau de mesure (par exemple les rayons géométriques des conducteurs, les positions des capteurs magnétiques par rapport au centre du câble, leur position angulaire par rapport aux conducteurs, ou leur sensibilité aux champs magnétiques) et des propriétés de l'environnement de mesure.

Ainsi, en l'absence de matériaux ferromagnétiques à proximité des capteurs, les coefficients Kij peuvent être déterminés de façon analytique au moyen de la relation de Biot-Savart.

Dans la plupart des applications industrielles, on pourra négliger les effets de proximité entre les conducteurs du câble 1, du fait d'une section relativement réduite de ces conducteurs et d'une fréquence de travail généralement de l'ordre de 50 ou de 60 Hertz, correspondant à celle d'un réseau électrique public. On peut bien entendu réaliser des mesures de courant pour des fréquences nettement supérieures à 60Hz.

Le nombre N de capteurs étant supérieur au nombre M de conducteurs, la matrice [K] n'est pas carrée. Par conséquent, pour déterminer l'intensité dans les conducteurs à partir des champs magnétiques [B], on réalise le calcul d'une matrice [K]⁺ pour finalement effectuer le calcul suivant :

$$[I] = [K]^+ . [B]$$

[K]⁺ est la matrice pseudo-inverse de Penrose de la matrice [K].

Les matrices [K] et [K]⁺ pourront être corrigées ou calculées en tenant compte de l'incidence du blindage 313 sur les mesures effectuées par les capteurs 300.

On mémorise les matrices [K] et [K]⁺ pour les différentes configurations de câble 1 et pour les différentes positions des capteurs 300 autour du câble 1, à l'issue des différentes simulations réalisées. Les matrices [K] et [K]⁺ peuvent par exemple être mémorisées dans le dispositif de calcul 330, ou être rendues accessibles à distance à ce dispositif de calcul 330.

Des matrices [K] et [K]⁺ seront avantageusement réalisées pour de nombreuses positions angulaires distinctes des capteurs 300 par rapport à un même câble 1, par exemple avec une résolution angulaire de préférence inférieure à 10°, avantageusement inférieure à 5°et préférentiellement inférieure à 2°. Ainsi, la position angulaire des capteurs par rapport au câble 1 en cours de mesure sera toujours très proche d'une position angulaire pour laquelle des matrices [K] et [K]⁺ sont disponibles. Les simulations numériques pourront générer des matrices [K] et [K]⁺ pour différentes configurations d'un même câble, en prenant par exemple en compte des erreurs de positionnement radial ou angulaire des conducteurs du câble, ou pour des erreurs de centrage ou de pivotement de l'anneau de mesure par rapport au câble 1. La bibliothèque de matrices [K] et [K]⁺ pourra être établie pour un ensemble de structures de câbles connues et présentant une forte probabilité de devoir être mesurées.

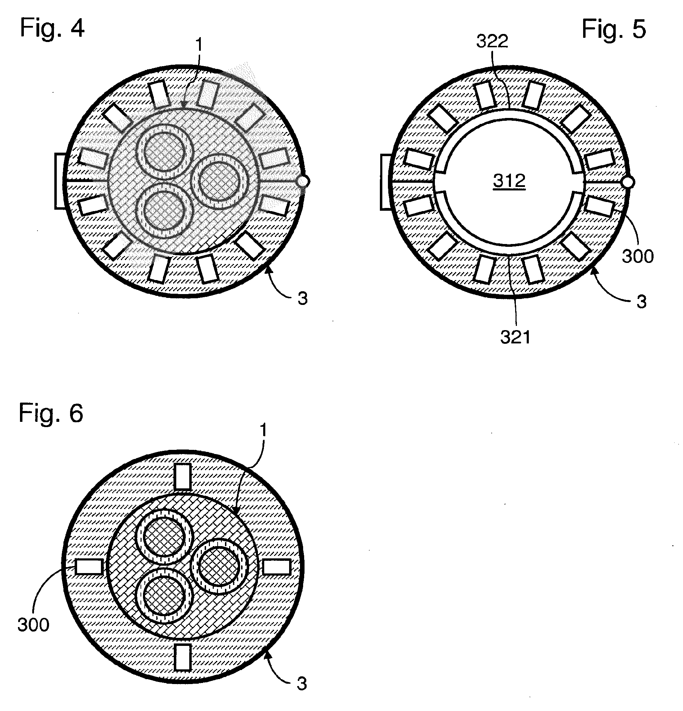

Lors de la mesure de courant proprement dite, on dispose le câble gainé 1 dans l'ouverture 312 du dispositif de mesure 3, comme illustré à la figure 4. Les capteurs 300 réalisent ensuite un ou plusieurs échantillonnages de valeurs de champs magnétiques respectifs. Le dispositif de calcul 330 collecte les valeurs de champs magnétiques mesurées par les capteurs 300 pour former un vecteur de champ magnétique [B].

Pour extrapoler les valeurs des courants traversant les conducteurs 110, 120 et 130, on procède à la détermination des matrices [K] et [K]⁺ correspondant le mieux au câble 1 mesuré.

Le dispositif de calcul 330 teste ainsi un ensemble de matrices [K] et [K]⁺ mémorisées et potentiellement représentatives du câble gainé 1 et de sa position par rapport à l'anneau de mesure.

Pour le vecteur de champ [B] mesuré, on calcule un vecteur résiduel [R], pour les différentes matrices [K] et [K]⁺ des configurations à tester :

$$[R]=[K].[K]^+.[B] - [B]$$

On sélectionne ensuite le couple de matrices [K] et [K]⁺ pour lesquelles le vecteur résiduel [R] est minimal. La matrice [K]⁺ est alors la plus représentative de la configuration du câble mesuré et du dispositif de mesure 3.

Une fois que la matrice [K]⁺ la plus représentative est sélectionnée, on calcule un vecteur [I] des courants traversant les conducteurs 110, 120 et 130 :

$$[I] = [K]^+. [B]$$

De façon connue en soi, on peut extrapoler l'amplitude de chacune des phases du courant triphasé traversant les conducteurs 110, 120 et 130 à partir d'un vecteur instantané [I] calculé. Les courants traversant les conducteurs 110, 120 et 130 peuvent également être extrapolés d'une succession de vecteurs [I] calculés.

Des exemples simplifiés de matrices [K] et [K]⁺ sont détaillés ci-dessous. Ces exemples sont basés sur des conducteurs disposés à une distance de 3 mm du centre du câble et au nombre de trois, un nombre de capteurs au nombre de quatre et disposés à une distance de 10 mm du centre du câble.

Trois configurations ont été simulées avec des outils de calcul numérique. Dans toutes ces configurations, les capteurs sont décalés à 90° autour de l'axe du câble, le premier capteur étant disposé à un angle de 0° dans un référentiel donné.

Dans une première configuration illustrée de façon schématique à la figure 6, les conducteurs sont disposés respectivement à 0°, 120° et 240° autour de l'axe du câble. Dans une deuxième configuration, les conducteurs sont disposés respectivement à 30°, 150° et 270° autour de l'axe du câble. Dans une troisième configuration, les conducteurs sont disposés respectivement à 60°, 180°, et 300° autour de l'axe du câble.

Pour la première configuration, les matrices [K] et [K]⁺ peuvent s'exprimer comme suit:

$$[K] = 1.0e^{-4} * \begin{bmatrix} 0.2857 & 0.1655 & 0.1655 \\ 0.1835 & 0.2595 & 0.1565 \\ 0.1538 & 0.2152 & 0.2152 \\ 0.1835 & 0.1565 & 0.2595 \end{bmatrix}$$

$$[K]^+ = 1.0e^{4} * \begin{bmatrix} 6.4019 & -1.0327 & -2.9259 & -1.0327 \\ -2.6144 & 6.0082 & 2.1023 & -3.6999 \\ -2.6144 & -3.6999 & 2.1023 & 6.0082 \end{bmatrix}$$

Pour la deuxième configuration, les matrices [K] et [K]⁺ peuvent s'exprimer comme suit:

$$[K] = 1.0e^{-4} * \begin{bmatrix} 0.2595 & 0.1565 & 0.1835 \\ 0.2152 & 0.2152 & 0.1538 \\ 0.1565 & 0.2595 & 0.1835 \\ 0.1655 & 0.1655 & 0.2857 \end{bmatrix}$$

$$[K]^+ = 1.0e^{4} * \begin{bmatrix} 6.0082 & 2.1023 & -3.6999 & -2.6144 \\ -3.6999 & 2.1023 & 6.0082 & -2.6144 \\ -1.0327 & -2.9259 & -1.0327 & 6.4019 \end{bmatrix}$$

Pour la troisième configuration, les matrices [K] et [K]⁺ peuvent s'exprimer comme suit:

$$[K] = 1.0e^{-4} * \begin{bmatrix} 0.2152 & 0.1538 & 0.2152 \\ 0.2595 & 0.1835 & 0.1565 \\ 0.1655 & 0.2857 & 0.1655 \\ 0.1565 & 0.1835 & 0.2595 \end{bmatrix}$$

$$[K]^+ = 1.0e^{4} * \begin{bmatrix} 2.1023 & 6.0082 & -2.6144 & -3.6999 \\ -2.9259 & -1.0327 & 6.4019 & -1.0327 \\ 2.1023 & -3.6999 & -2.6144 & 6.0082 \end{bmatrix}$$

Des simulations ont été réalisées avec une position angulaire aléatoire d'un anneau de mesure autour d'un câble 1 dans un modèle numérique. La simulation a été réalisée avec une dizaine de capteurs répartis de façon homogène autour de l'axe de l'anneau de mesure, avec un câble présentant trois conducteurs. Les capteurs 300 de l'anneau de mesure ont été disposés à une distance de 10 mm de l'axe du câble 1. Les conducteurs du câble 1 ont été disposés à une distance de 3 mm de cet axe. Des courants de -0,5A, -0,5A et 1 A ont été appliqués dans les conducteurs de ce modèle numérique.

Après sélection de la matrice [K]⁺ la plus représentative, la simulation a permis de déduire des intensités de -0,46A, -0,49A et 1 A. Ainsi, même avec un modèle relativement sommaire, on a pu déterminer que la mesure de courant effectuée avec un dispositif de mesure 3 selon l'invention présente une certaine précision.

Des câbles gainés 1 de différents diamètres extérieurs peuvent faire l'objet d'une mesure de courant. Afin de pouvoir utiliser un même anneau de mesure pour différents diamètres de câble, l'anneau de mesure comporte avantageusement des moyens d'adaptation à différents diamètres.

Dans l'exemple illustré à la figure 5, l'anneau de mesure comporte des cales 321 et 322 venant se fixer sur sa paroi interne. Les cales 321 et 322 permettent ainsi de réduire la section de l'orifice traversant 312. Avec différents jeux de cales, l'anneau de mesure peut ainsi être fixé sur différents diamètres de câbles gainés, tout en conservant un bon centrage par rapport à ce câble 1.

**Revendications**

1. Dispositif de mesure de courants (3) dans les conducteurs d'un câble gainé d'un réseau polyphasé, comprenant :

    - au moins trois capteurs magnétiques (300) disposés autour d'un orifice central (312) destiné à être traversé par le câble à mesurer présentant un nombre de conducteurs inférieur au nombre de capteurs ;
    - un dispositif de calcul (330) ;

**caractérisé en ce que** le dispositif de calcul est configuré pour :

- accéder à une bibliothèque de matrices [K] et [K]$^+$, avec [I]=[K]$^+$.[B] pour une configuration de câble donnée et une position angulaire donnée des capteurs autour de ce câble donné, avec [I] un vecteur de courant traversant le câble ayant la configuration donnée lorsqu'un vecteur de champ magnétique [B] est mesuré sur lesdits capteurs, avec [K]$^+$ une matrice pseudo-inverse de la matrice [K] ;
- former un vecteur [B] incluant une mesure de champ magnétique de chacun desdits capteurs ;
- pour différentes configurations de câbles et différentes positions angulaires desdits capteurs par rapport à ces câbles, calculer un vecteur résiduel [R] = [K].[K]$^+$.[B] - [B] ;
- sélectionner la matrice [K]$^+$ pour laquelle la norme du vecteur [R] est minimale ;
- calculer [I] = [K]$^+$.[B] avec [K]$^+$ ladite matrice sélectionnée.

2. Dispositif de mesure de courant (3) selon la revendication 1, comprenant en outre une mémoire mémorisant ladite bibliothèque de matrices, ladite mémoire étant accessible par le dispositif de calcul (330).

3. Dispositif de mesure de courant selon la revendication 1 ou 2, comprenant au moins six capteurs magnétiques (300) répartis uniformément autour dudit orifice central (312).

4. Dispositif de mesure de courant (3) selon l'une quelconque des revendications précédentes, comprenant en outre un blindage magnétique (313), lesdits capteurs étant disposés entre deux faces latérales et une face radiale externe dudit blindage (313).

5. Dispositif de mesure de courant (3) selon l'une quelconque des revendications précédentes, dans lequel la bibliothèque de matrices comprend plusieurs matrices [K] et [K]$^+$ pour une même configuration de câble donnée, lesdites matrices [K] et [K]$^+$ pour cette même configuration correspondant à différentes positions angulaires des capteurs par rapport à ce câble, l'écart entre ces positions angulaires étant inférieur ou égal à 10°.

6. Procédé de mesure de courant dans M conducteurs (110,120,130) d'un câble gainé (1) d'un réseau polyphasé, avec M au moins égal à 2, le procédé comprenant les étapes de :

- disposer N capteurs magnétiques (300) autour d'une section du câble (1), avec N supérieur à M ;
- former un vecteur [B] incluant la mesure de champ magnétique de chacun desdits capteurs ;
- pour différentes configurations de câbles et différentes positions angulaires des N capteurs (300) par rapport à ces câbles, calculer un vecteur résiduel [R] = [K].[K]$^+$.[B] - [B], avec [K] une matrice définie telle que [I] = [K]$^+$.[B] pour une configuration de câble donnée et pour une position angulaire donnée des N capteurs autour de ce câble donné, avec [K]$^+$ une matrice pseudo-inverse de la matrice [K], avec [I] le courant traversant le câble de la configuration donnée avec la position angulaire donnée des N capteurs ;
- sélectionner la matrice [K]$^+$ pour laquelle la norme du vecteur [R] est minimale ;
- calculer [I] = [K]$^+$. [B] avec [K]$^+$ ladite matrice sélectionnée.

7. Procédé de mesure de courant selon la revendication 6, dans lequel M est égal à 3.

8. Procédé de mesure de courant selon la revendication 6 ou 7, dans lequel on dispose au moins six capteurs magnétiques (300) répartis uniformément autour dudit orifice central (312).

9. Procédé de mesure de courant selon l'une quelconque des revendications 6 à 8, dans lequel le calcul du vecteur résiduel est réalisé avec plusieurs matrices [K] et [K]$^+$ pour une même configuration de câble donnée, lesdites matrices [K] et [K]$^+$ pour cette même configuration correspondant à différentes positions angulaires des capteurs par rapport ce câble, l'écart entre ces positions angulaires étant inférieur ou égal à 10°.

10. Procédé de mesure de courant selon l'une quelconque des revendications 6 à 9, dans lequel [K]$^+$ est la matrice pseudo inverse de Penrose de la matrice [K].

11. Procédé de mesure de courant selon l'une quelconque des revendications 6 à 10, dans lequel lesdits capteurs (300) sont disposés dans un même plan perpendiculaire à l'axe du câble (1).

**Patentansprüche**

1. Vorrichtung zur Messung von Strömen (3) in den Leitungen eines ummantelten Kabels eines mehrphasigen Netzes, umfassend:

   - mindestens drei Magnetsensoren (300), die um eine zentrale Öffnung (312) angeordnet sind, die dazu bestimmt ist, von dem zu messenden Kabel durchquert zu werden, das eine Anzahl von Leitungen aufweist, die niedriger als die Anzahl der Sensoren ist;
   - eine Rechenvorrichtung (330);

   **dadurch gekennzeichnet, dass** die Rechenvorrichtung konfiguriert ist, um:

   - auf eine Bibliothek von Matrizen [K] und $[K]^+$ zuzugreifen, wobei [I] = $[K]^+$.[B] für eine bestimmte Kabelkonfiguration und eine bestimmte Winkelposition der Sensoren um dieses bestimmte Kabel ist, wobei [I] ein Stromvektor ist, der das Kabel durchquert, das die bestimmte Konfiguration aufweist, wenn ein Magnetfeldvektor [B] an den Sensoren gemessen wird, wobei $[K]^+$ eine pseudoinverse Matrix der Matrix [K] ist;
   - einen Vektor [B] einschließlich einer Magnetfeldmessung von jedem der Sensoren zu bilden;
   - für verschiedene Kabelkonfigurationen und verschiedene Winkelpositionen der Sensoren gegenüber diesen Kabeln einen Restvektor [R] = [K]. $[K]^+$.[B]-[B] zu berechnen;
   - die Matrix $[K]^+$ auszuwählen, für die die Norm des Vektors [R] minimal ist;
   - [I] = $[K]^+$.[B] zu berechnen, wobei $[K]^+$ die ausgewählte Matrix ist.

2. Vorrichtung zur Messung von Strom (3) nach Anspruch 1, die ferner einen Speicher aufweist, der die Matrix-Bibliothek speichert, wobei der Speicher durch die Rechenvorrichtung (330) zugänglich ist.

3. Vorrichtung zur Messung von Strom nach Anspruch 1 oder 2, die mindestens sechs Magnetsensoren (300) aufweist, die gleichmäßig um die zentrale Öffnung (312) verteilt sind.

4. Vorrichtung zur Messung von Strom (3) nach einem der vorhergehenden Ansprüche, die ferner eine magnetische Abschirmung (313) aufweist, wobei die Sensoren zwischen zwei Seitenflächen und einer radialen Außenfläche der Abschirmung (313) angeordnet sind.

5. Vorrichtung zur Messung von Strom (3) nach einem der vorhergehenden Ansprüche, wobei die Matrix-Bibliothek mehrere Matrizen [K] und $[K]^+$ für eine gleiche bestimmte Kabelkonfiguration aufweist, wobei die Matrizen [K] und $[K]^+$ für diese gleiche Konfiguration verschiedenen Winkelpositionen der Sensoren gegenüber diesem Kabel entsprechen, wobei der Abstand zwischen diesen Winkelpositionen weniger als oder gleich 10° beträgt.

6. Verfahren zur Messung von Strom in M Leitungen (110, 120, 130) eines ummantelten Kabels (1) eines mehrphasigen Netzes, wobei M mindestens gleich 2 ist, wobei das Verfahren die folgenden Schritte umfasst:

   - Anordnen von N Magnetsensoren (300) um einen Abschnitt des Kabels (1), wobei N höher als M ist;
   - Bilden eines Vektors [B] einschließlich der Magnetfeldmessung von jedem der Sensoren;
   - Berechnen für verschiedene Kabelkonfigurationen und verschiedene Winkelpositionen der N Sensoren (300) gegenüber diesen Kabeln eines Restvektors [R] = [K]. $[K]^+$.[B]-[B], wobei [K] eine Matrize ist, die wie [I] = $[K]^+$.[B] für eine bestimmte Kabelkonfiguration und eine bestimmte Winkelposition der N Sensoren um das bestimmte Kabel definiert ist, wobei $[K]^+$ eine pseudoinverse Matrix der Matrix [K] ist, wobei [I] der Strom ist, der das Kabel der bestimmten Konfiguration mit der bestimmten Winkelposition der N Sensoren durchquert;
   - Auswählen der Matrix $[K]^+$, für die die Norm des Vektors [R] minimal ist;
   - Berechnen von [I]=$[K]^+$.[B], wobei $[K]^+$ die ausgewählte Matrix ist.

7. Verfahren zur Messung von Strom nach Anspruch 6, wobei M gleich 3 ist.

8. Verfahren zur Messung von Strom nach einem der Ansprüche 6 oder 7, wobei mindestens sechs Magnetsensoren (300) gleichmäßig um die zentrale Öffnung (312) verteilt angeordnet werden.

9. Verfahren zur Messung von Strom nach einem der Ansprüche 6 bis 8, wobei das Berechnen des Restvektors mit mehreren Matrizen [K] und $[K]^+$ für eine gleiche bestimmte Kabelkonfiguration durchgeführt wird, wobei die Matrizen [K] und $[K]^+$ für diese gleiche Konfiguration verschiedenen Winkelpositionen der Sensoren gegenüber diesem Kabel entsprechen, wobei der Abstand zwischen diesen Winkelpositionen weniger als oder gleich 10° beträgt.

10. Verfahren zur Messung von Strom nach einem der Ansprüche 6 bis 9, wobei [K]$^+$ die pseudoinverse Matrix von Penrose der Matrix [K] ist.

11. Verfahren zur Messung von Strom nach einem der Ansprüche 6 bis 10, wobei die Sensoren (300) in einer gleichen Ebene senkrecht zu der Achse des Kabels (1) angeordnet sind.

**Claims**

1. Device for measuring currents (3) in the conductors of a sheathed cable of a polyphase network, comprising:

   - at least three magnetic sensors (300) positioned around a central aperture (312) through which the cable to be measured, having a number of conductors that is smaller than the number of sensors, is intended to pass;
   - a computing device (330);

   **characterized in that** the computing device is configured for:

   - accessing a library of matrices [K] and [K]$^+$, where [I] = [K]$^+$.[B] for a given cable configuration and a given angular position of the sensors around this given cable, where [I] is a vector of the current flowing through the cable having the given configuration when a magnetic field vector [B] is measured at said sensors, where [K]$^+$ is a pseudo-inverse matrix of the matrix [K];
   - forming a vector [B] including a measurement of the magnetic field of each of said sensors;
   - for various configurations of cables and various angular positions of said sensors with respect to these cables, calculating a residual vector [R] = [K].[K]$^+$.[B] - [B];
   - selecting the matrix [K]$^+$ for which the norm of the vector [R] is minimal;
   - calculating [I] = [K]$^+$.[B] where [K]$^+$ is said selected matrix.

2. Current-measuring device (3) according to Claim 1, additionally comprising a memory memorizing said library of matrices, said memory being accessible by the computing device (330).

3. Current-measuring device according to Claim 1 or 2, comprising at least six magnetic sensors (300) that are uniformly distributed around said central aperture (312).

4. Current-measuring device (3) according to any one of the preceding claims, additionally comprising a magnetic shielding (313), said sensors being positioned between two lateral faces and one outer radial face of said shielding (313).

5. Current-measuring device (3) according to any one of the preceding claims, in which the library of matrices comprises multiple matrices [K] and [K]$^+$ for one and the same given cable configuration, said matrices [K] and [K]$^+$ for this same configuration corresponding to various angular positions of the sensors with respect to this cable, the gap between these angular positions being less than or equal to 10°.

6. Method for measuring current in M conductors (110, 120, 130) of a sheathed cable (1) of a polyphase network, where M is at least equal to 2, the method comprising the steps of:

   - positioning N magnetic sensors (300) around a section of the cable (1), where N is greater than M;
   - forming a vector [B] including the measurement of the magnetic field of each of said sensors;
   - for various configurations of cables and various angular positions of the N sensors (300) with respect to these cables, calculating a residual vector [R] = [K].[K]$^+$.[B] - [B], where [K] is a matrix defined such that [I] = [K]$^+$.[B] for a given cable configuration and for a given angular position of the N sensors around this given cable, where [K]$^+$ is a pseudo-inverse matrix of the matrix [K], where [I] is the current flowing through the cable of the given configuration with the given angular position of the N sensors;
   - selecting the matrix [K]$^+$ for which the norm of the vector [R] is minimal;
   - calculating [I] = [K]$^+$.[B] where [K]$^+$ is said selected matrix.

7. Current-measuring method according to Claim 6, in which M is equal to 3.

8. Current-measuring method according to Claim 6 or 7, in which at least six magnetic sensors (300) are positioned in a uniform distribution around said central aperture (312).

9. Current-measuring method according to any one of Claims 6 to 8, in which the computation of the residual vector is carried out using multiple matrices [K] and [K]$^+$ for one and the same given cable configuration, said matrices [K] and [K]$^+$ for this same configuration corresponding to various angular positions of the sensors with respect to this cable, the gap between these angular positions being less than or equal to 10°.

10. Current-measuring method according to any one of Claims 6 to 9, in which [K]$^+$ is the Penrose pseudo-inverse matrix of the matrix [K].

11. Current-measuring method according to any one of Claims 6 to 10, in which said sensors (300) are positioned in one and the same plane that is perpendicular to the axis of the cable (1).

Fig. 1

Fig. 2

Fig. 3

Fig. 4

Fig. 5

Fig. 6

## RÉFÉRENCES CITÉES DANS LA DESCRIPTION

**Documents brevets cités dans la description**

- US 5473244 A
- WO 0150142 A
- US 20090048806 A
- US 7755347 B